# EUROPEAN PATENT APPLICATION

(11) **EP 2 562 600 A2**
(43) Date of publication of application: **27.02.2013**
(21) Application number: 12181526.0
(22) Date of filing: 23.08.2012
(51) Int. Cl.: G03F 7/20

(54) **Multi-beam exposure scanning method and apparatus and printing plate manufacturing method**

(30) Priority: 26.08.2011 JP 2011185121
(71) Applicant: Fujifilm Corporation, Minato-ku Tokyo 106-8620 (JP)
(72) Inventor: Miyagawa, Ichirou, Kanagawa 258-8538 (JP); Shigeta, Norimasa, Kanagawa 258-8538 (JP)
(74) Representative: Klunker . Schmitt-Nilson . Hirsch

(57) **Abstract**

A multi-beam exposure scanning method includes: simultaneously emitting a plurality of beams with an interval between scanning lines toward a recording medium; and performing engraving on a surface of the recording medium by performing exposure scanning a plurality of times with a same scanning line, the method further includes: repeatedly performing interlaced exposure using a beam group with an interval between adjacent beams N times (N is an integer equal to 2 or more) larger than the interval between the scanning lines Nxm times (m is an integer equal to 2 or more) on a first area surrounding a flat-shaped target area to be left on the surface, to expose each of the scanning lines m times; and performing non-interlaced exposure using a beam group with an interval between adjacent beams equal to the interval between the scanning lines on a second area, which is outside the first area.

## Description

### BACKGROUND OF THE INVENTION

### Field of the Invention

The presently disclosed subject matter relates to a multi-beam exposure scanning method and apparatus and, in particular, to a multi-beam exposure technique suitable for manufacturing a printing plate, such as a flexographic plate, and a printing plate manufacturing technique to which the multi-beam exposure technique can be applied.

### Description of the Related Art

Conventionally, a surface of a plate member is engraved by using a multi-beam head capable of irradiation with a plurality of laser beams to form asperities on the plate member. When engraving is performed on the plate with this multi-beam exposure, it is extremely difficult to stably form fine shapes, such as small dots and narrow lines, because of an influence of heat of adjacent beams.

To solve the problem described above, Japanese Patent Application Laid-Open No. 2010-134292 discloses a technique of causing light emission of all beams in a deep engraving area, causing exposure in an interlaced manner for every N lines in order to reduce the influence of heat of adjacent beams in an area near an edge of a front surface portion, and exposing and scanning lines therebetween N times to expose all lines.

### SUMMARY OF THE INVENTION

With the exposure disclosed in Japanese Patent Application Laid-Open No. 2010-134292, the influence of heat of adjacent beams can be significantly reduced. Even so, however, there is a disadvantage in which a dot formation area is slightly influenced by heat and periodic uneven streaks associated with multi-beam exposure are prone to be visually indentified.

The presently disclosed subject matter was made in view of these circumstances, and suggests a multi-beam exposure scanning method and apparatus and a printing plate manufacturing method capable of further reducing periodic uneven steaks associated with multi-beam exposure.

To achieve the object described above, in a multi-beam exposure scanning method according to the presently disclosed subject matter, a plurality of beams are simultaneously emitted with a predetermined interval (space) between scanning lines toward a recording medium for exposure scanning a plurality of times with a same scanning line, thereby performing engraving on a surface of the recording medium. And, interlaced exposure using a beam group with a interval between adjacent beams N times (N is an integer and is 2 or more) larger than the interval (space) between the scanning lines is repeatedly performed Nxm times (m is an integer and is 2 or more) on a first area, which is an area surrounding a flat-shaped target area to be left on the surface of the recording medium to be exposed, to expose each of the scanning lines m times; and non-interlaced exposure using a beam group with an interval (space) between adjacent beams equal to the interval (space) between the scanning lines is performed on a second area, which is outside with respect to the first area.

According to the presently disclosed subject matter, efficient engraving can be performed on the second area, and precise engraving can be performed on the first area. Therefore, periodic uneven streaks can be reduced.

According to the presently disclosed subject matter, periodic uneven streaks can be reduced.

### BRIEF DESCRIPTION OF THE DRAWINGS

Fig. 1 is a structural diagram of a plate making apparatus to which a multi-beam exposure scanning apparatus according to an embodiment of the presently disclosed subject matter is applied;
Fig. 2 is a structural diagram of an optical fiber array unit arranged in a exposure array;
Fig. 3 is an enlarged view of a light emitting unit of the optical fiber array unit;
Fig. 4 is an overview diagram of an image-forming optical system of the optical fiber array unit;
Fig. 5 is an explanatory diagram illustrating a relation between an example of arrangement of an optical fiber and scanning lines in the optical fiber array unit;
Fig. 6 is a plan view illustrating an overview of a scanning exposure system of a plate making apparatus according to the embodiment;
Fig. 7 is a block diagram illustrating the structure of a control system of a plate making apparatus according to the embodiment;
Fig. 8 is a diagram illustrating a precise engraving area and a rough engraving area;
Fig. 9 is a diagram illustrating first exposure scanning;
Fig. 10 is a diagram illustrating second exposure scanning;
Fig. 11 is a diagram illustrating third exposure scanning;
Fig. 12 is a diagram illustrating fourth exposure scanning;
Fig. 13 is a diagram illustrating a modification example of a sequence of exposure scanning;
Fig. 14 is a diagram illustrating sub-scanning feeds with a movement by 32 ch for every four main scans;
Fig. 15 is a diagram illustrating sub-scanning feeds with a movement by 29 ch for every four main scans;
Fig. 16 is a diagram illustrating sub-scanning feeds with a movement by 8 ch for every main scan;
Fig. 17 is a diagram illustrating sub-scanning feeds with a movement by 7 ch or 9 ch for every main scan; and
Figs. 18A, 18B, and 18C are explanatory diagrams illustrating an overview of a flexographic plate making method.

### DETAILED DESCRIPTION OF THE PREFERRED EMBODIMENTS

A preferred embodiment of the presently disclosed subject matter is described in detail below by reference to the attached drawings.

### <An example of structure of the multi-beam exposure scanning apparatus>

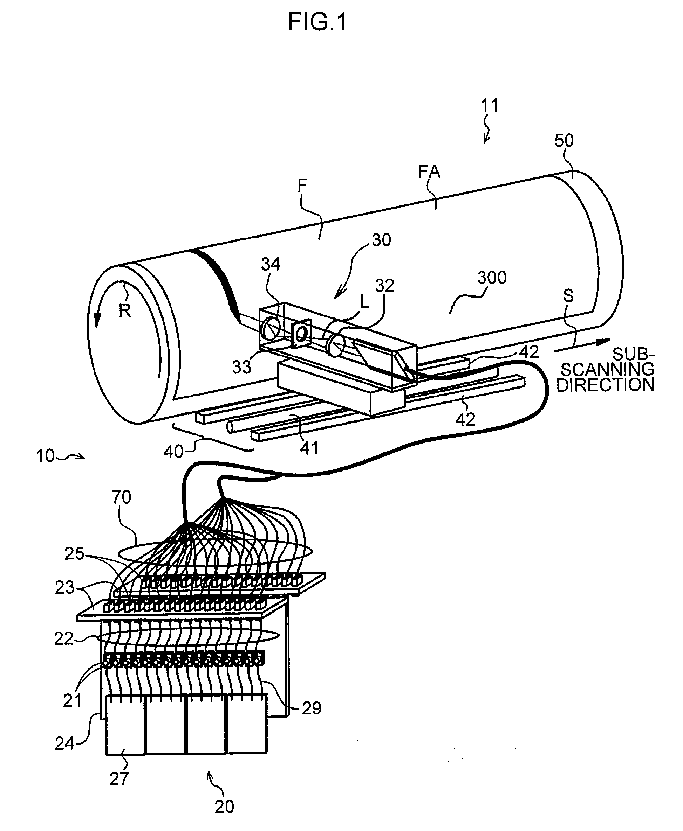

Fig. 1 is a structural diagram of a plate making apparatus to which a multi-beam exposure scanning apparatus is applied, according to an embodiment of the presently disclosed subject matter. In a plate making apparatus 11 illustrated in Fig. 1, a sheet-shaped plate member F (corresponding to a "recording medium") is fixed to an outer circumferential surface of a drum 50 having a cylindrical shape. The drum 50 is rotated in an arrow R direction (a main-scanning direction) in Fig. 1. A plurality of laser beams according to image data of an image to be engraved (recorded) on the plate member F are emitted from an exposure head 30 of a laser recording apparatus 10 toward the plate member F. And, scanning is performed with the exposure head 30 with predetermined pitches in a sub-scanning direction (an arrow S direction in Fig. 1) orthogonal to the main-scanning direction. Thus, a two-dimensional image can be engraved (recorded) on the surface of the plate member F at high speed. Here, engraving on a rubber plate or a resin plate for flexography is described as an example.

The laser recording apparatus 10 to be used for the plate making apparatus 11 includes a light source unit 20 generating a plurality of laser beams; an exposure head 30 irradiating the plate member F with the plurality of laser beams generated by the light source unit 20; and an exposure head moving unit 40 moving the exposure head 30 along the sub-scanning direction.

The light source unit 20 includes a plurality of (here, 32 in total) semiconductor lasers 21. Light from each of the semiconductor lasers 21 is individually transmitted via optical fibers 22 and 70 to an optical fiber array unit 300 of the exposure head 30.

In this embodiment, broad-area semiconductor lasers (wavelength: 915 mm) are used as the semiconductor lasers 21. The semiconductor lasers 21 are arranged in a line on a light source substrate 24. The semiconductor lasers 21 are individually coupled to one ends of the optical fibers 22, and the other ends of the optical fibers 22 are each connected to an adaptor of an FC-type optical connector (Fiber transmission system optical Connector) 25.

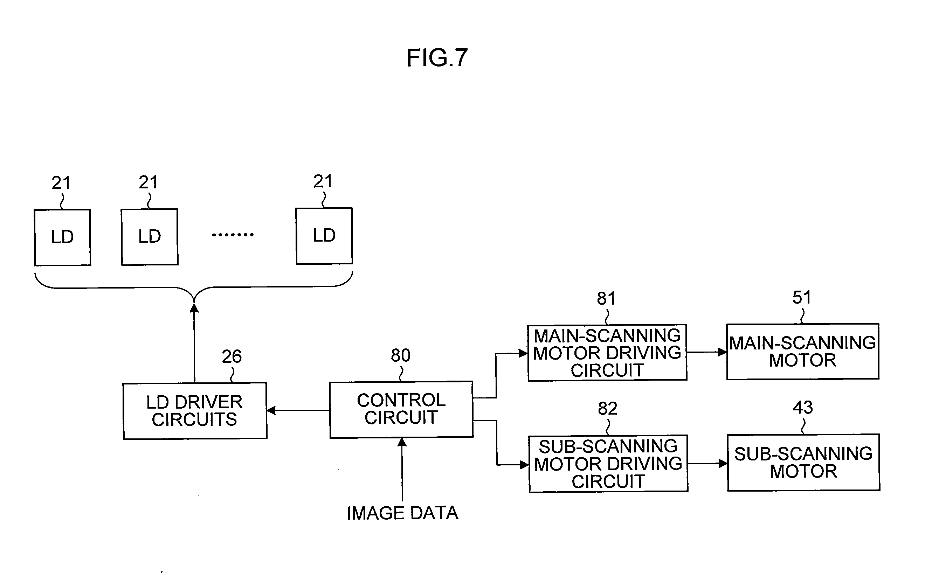

An adaptor substrate 23 supports the FC-type optical connector 25 and is mounted vertically on one end of the light source substrate 24. Also, an LD (Laser Diode) driver substrate 27 equipped with LD driver circuits (not illustrated in Fig. 1 and denoted as a reference numeral 26 in Fig. 7) driving the semiconductor lasers 21 are mounted on the other end of the light source substrate 24. Each of the semiconductor lasers 21 is connected to a corresponding one of the LD driver circuits via an individual wiring member 29. With this, each of the semiconductor lasers 21 is individually driven and controlled.

In the present embodiment, multi-mode optical fibers having a relatively large core diameter are applied to the optical fibers 70 in order to obtain high output of laser beams. Specifically, in the present embodiment, optical fibers having a core diameter of 105 µm are used. Also, the semiconductor lasers 21 for use have a maximum output on the order of 10 W. Specifically, for example, those having a core diameter of 105 µm and an output of 10 W distributed from JDS Uniphase Corporation (6398-L4) can be adopted.

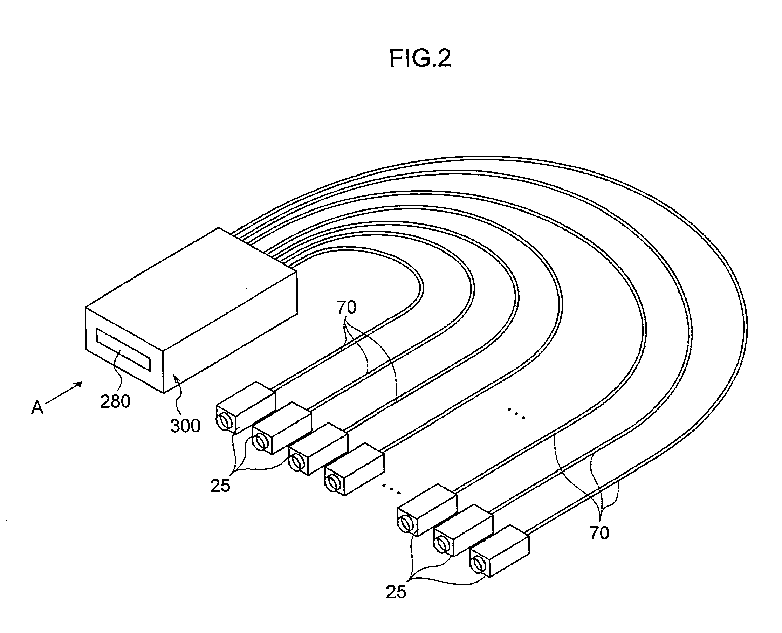

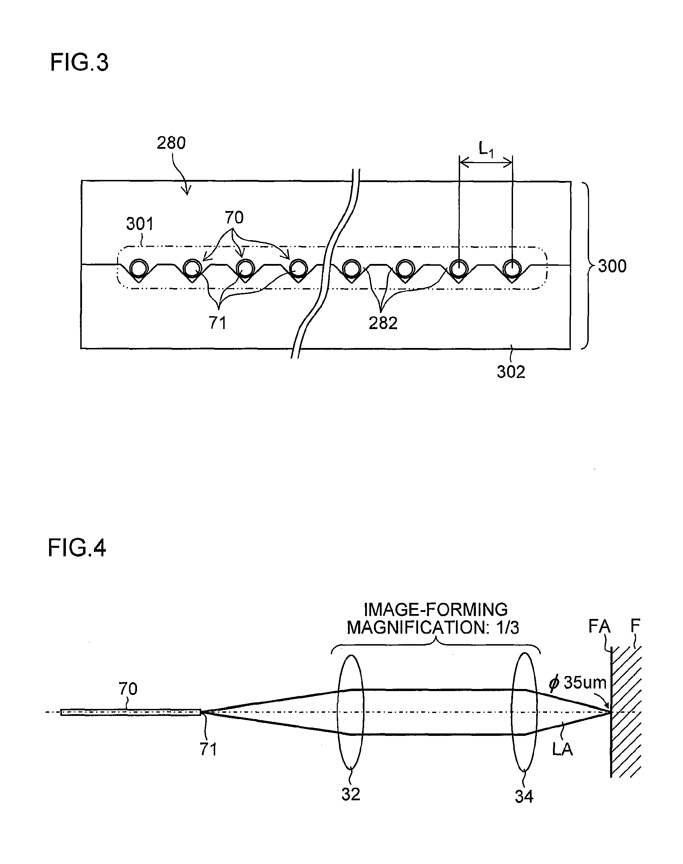

On the other hand, the optical fiber array unit 300 gathering and emitting laser beams emitted from the plurality of semiconductor lasers 21 is provided on the exposure head 30. A light emitting unit (not illustrated in Fig. 1 and denoted as a reference numeral 280 in Fig. 2) of the optical fiber array unit 300 is configured in a manner such that emission ends of 32 optical fibers 70 led from the semiconductor lasers 21 are arranged in a line (refer to Fig. 3).

Also, in the exposure head 30, a collimator lens 32, an opening member 33, and an imaging lens 34 are arranged in a line in sequence from a light emitting unit side of the optical fiber array unit 300. The combination of the collimator lens 32 and the imaging lens 34 configures an imaging optical system. The opening member 33 is arranged at a position so that the opening is a far field position when viewed from an optical fiber array unit 300 side. With this, a light amount limiting effect can be equally given to all laser beams emitted from the optical fiber array unit 300.

The exposure head moving unit 40 includes a ball screw 41 and two rails 42 arranged in a manner such that a longitudinal direction thereof is along the sub-scanning direction. By activating a sub-scanning motor (not illustrated in Fig. 1 and denoted as a reference numeral 43 in Fig. 7) and driving the ball screw 41 by rotation, the exposure head 30 arranged on the ball screw 41 can be moved in the sub-scanning direction as being guided by the rails 42. Also, the drum 50 can be driven by rotation in an arrow R direction in Fig. 1 by activating a main-scanning motor (not illustrated in Fig. 1 and denoted as a reference numeral 51 in Fig. 7). With this, a main scan is performed.

Fig. 2 is a structural diagram of the optical fiber array unit 300, and Fig. 3 is an enlarged view (a view from an arrow A in Fig. 2) of the light emitting unit 280. As illustrated in Fig. 3, on the light emitting unit 280 of the optical fiber array unit 300, optical fibers 70 having a cladding diameter of 125 µm and a core diameter of 105 µm and equidistantly emitting 32 light beams are arranged in a straight line.

The optical fiber array unit 300 has a base (a V-groove substrate) 302, and V-shaped grooves 282 as many as the number of the semiconductor lasers 21, that is, 32 V-shaped grooves 282, are formed in the base 302 so as to be adjacent to each other with a predetermined space. In each of the V-shaped grooves 282 in the base 302, the other end of each of the optical fiber 70, that is, an optical fiber end 71, fit in. With this, an optical fiber end group 301 with the optical fiber ends is arranged in a straight line. Therefore, from the optical emitting unit 280 of the optical fiber array unit 300, these plurality of (32) laser beams are simultaneously emitted.

Fig. 4 is an overview diagram of an image-forming optical system of the optical fiber array unit 300. As illustrated in Fig. 4, with imaging means including the collimator lens 32 and the imaging lens 34 an image is formed from the laser beams emitted from the light emitting unit 280 of the optical fiber array unit 300 near an exposure surface (a front surface) FA of the plate member F at a predetermined image-forming magnification. In the present embodiment, the image-forming magnification is assumed to 1/3. With this, a laser beam LA emitted from the optical fiber end 71 having a core diameter of 105 µm has a spot diameter of ϕ 35 µm.

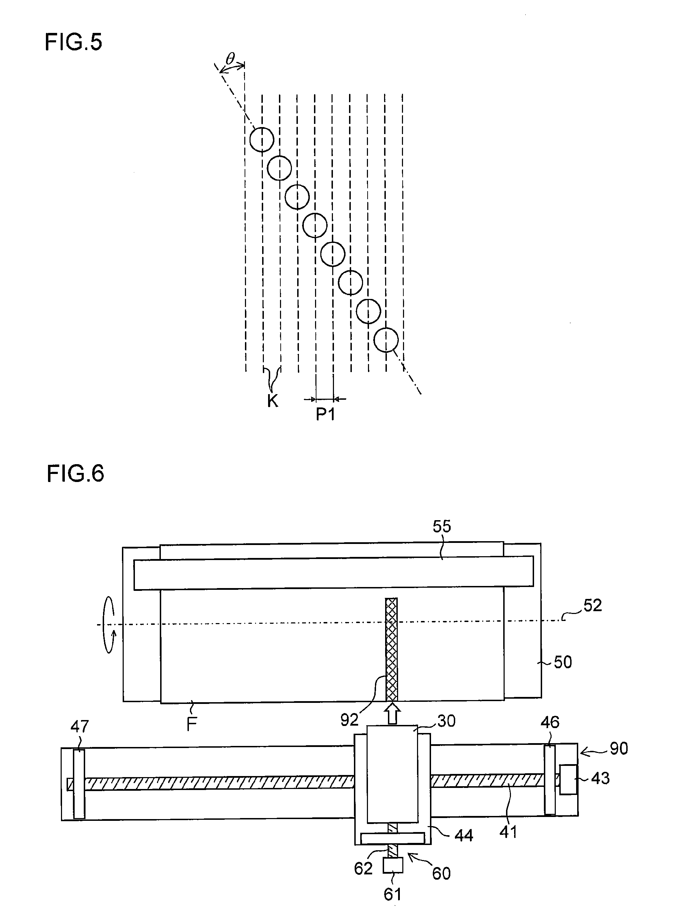

In the exposure head 30 having the image-forming system as described above, by designing as appropriate an interval between adjacent fibers (L1 in Fig. 3) of the optical fiber array unit 300 described with reference to Fig. 3 and a tilt angle (an angle 0 in Fig. 5) of an arranging direction (an array direction) of the optical fiber end group 301 when the optical fiber array unit 300 is fixed, as illustrated in Fig. 5, an interval P1 between scanning lines (main scanning lines) K subjected to exposure with laser beams emitted from optical fibers arranged at adjacent positions can be set at 10.58 µm (corresponding to a resolution of 2400 dpi in the sub-scanning direction).

By using the above-structured exposure head 30, a range of 32 lines (one swath) can be simultaneously scanned for exposure.

Fig. 6 is a plan view illustrating an overview of a scanning exposure system of in the plate making apparatus 11 illustrated in Fig. 1. The exposure head 30 includes a focus position changing mechanism 60 and a mechanism 90 for intermittently feeding in the sub-scanning direction.

The focus position changing mechanism 60 includes a motor 61 and a ball screw 62 for moving the exposure head 30 forward and backward with respect to a surface of the drum 50. With the control by the motor 61, a focus position can be moved by approximately 339 µm in approximately 0.1 seconds. The intermittent feeding mechanism 90 forms the exposure head moving unit 40 described with reference to Fig. 1 and, as illustrated in Fig. 6, includes a ball screw 41 and a sub-scanning motor 43 for rotating the ball screw 41. The exposure head 30 is fixed to a stage 44 on the ball screw 41. With the control by the sub-scanning motor 43, the exposure head 30 can be intermittently fed by one swath (in the case of 2400 dpi, 10.58µm×64ch=677.3 µm) in approximately 0.1 seconds.

In Fig. 6, reference numerals 46 and 47 denote bearings rotatably supporting the ball screw 41. A reference numeral 55 denotes a chuck member chucking the plate member F on the drum 50. The position of this chuck member 55 is in a non-recording area where exposure (recording) by the exposure head 30 is not performed. While the drum 50 is being rotated, the plate member F on this rotating drum 50 is irradiated with laser beams of 32 channels from the exposure head 30, an exposure range 92 of 32 channels (one swath) is exposed without a gap, thereby performing engraving (image recording) with one swath width on the surface of the plate member F. Then, when the chuck member 55 passes in front of the exposure head 30 with the rotation of the drum 50 (in the non-recording area of the plate member F), intermittent feeding is performed in the sub-scanning direction, thereby exposing the next one swath. By repeating this exposure scanning by intermittent feeds in the sub-scanning direction, a desired image is formed on the entire surface of the main material F.

While the sheet-shaped plate member F (recording medium) is used in the present example, a cylindrical recording medium (a sleeve type) can be used.

### <Structure of the control system>

Fig. 7 is a block diagram illustrating the structure of a control system in the plate making apparatus 11. The plate making apparatus 11 includes the LD driver circuits 26 driving each of the semiconductor lasers 21 according to two-dimensional image data to be engraved, a main-scanning motor 51 rotating the drum 50, a main-scanning motor driving circuit 81 driving the main-scanning motor 51, a sub-scanning motor driving circuit 82 driving the sub-scanning motor 43, and a control circuit 80. The control circuit 80 controls the LD driver circuits 26 and each of the motor driving circuits (81 and 82).

To the control circuit 80, image data representing an image to be engraved (recorded) on the plate member F. Based on this image data, the control circuit 80 controls the driving of the main-scanning motor 51 and the sub-scanning motor 43, and also individually controls an output of each of the semiconductor lasers 21 (ON/OFF control and laser beam power control).

### <Beam control in engraving areas>

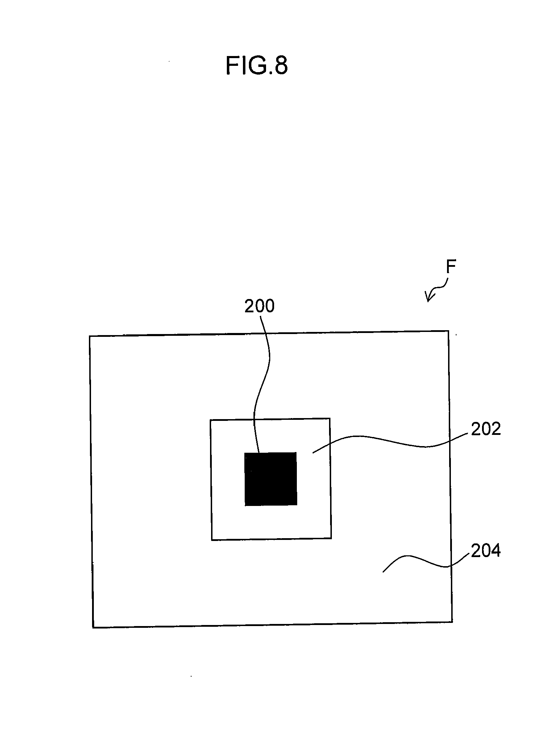

Next, an exposure scanning process when a printing plate is manufactured by a multi-beam exposure system is described. Here, as illustrated in Fig. 8, a peripheral part (a surrounding part) of a flat shape (a print surface) 200 to be left on the surface of the plate member F is taken as a precise engraving area (a first area) 202, and a further peripheral part (outside) thereof is taken as a rough engraving are (a second area) 204.

In the present embodiment, by using the exposure head 30 having the optical fiber array unit 300 illustrated in Fig. 3, a main scan (exposure scanning) is performed four times at each sub-scanning positions (without moving the exposure head 30). Also, the precise engraving area 202 is subjected to interlaced exposure by using beams with a space therebetween twice as large as the interval between the scanning lines, and the rough engraving area 204 is subjected to simultaneous exposure by using all beams.

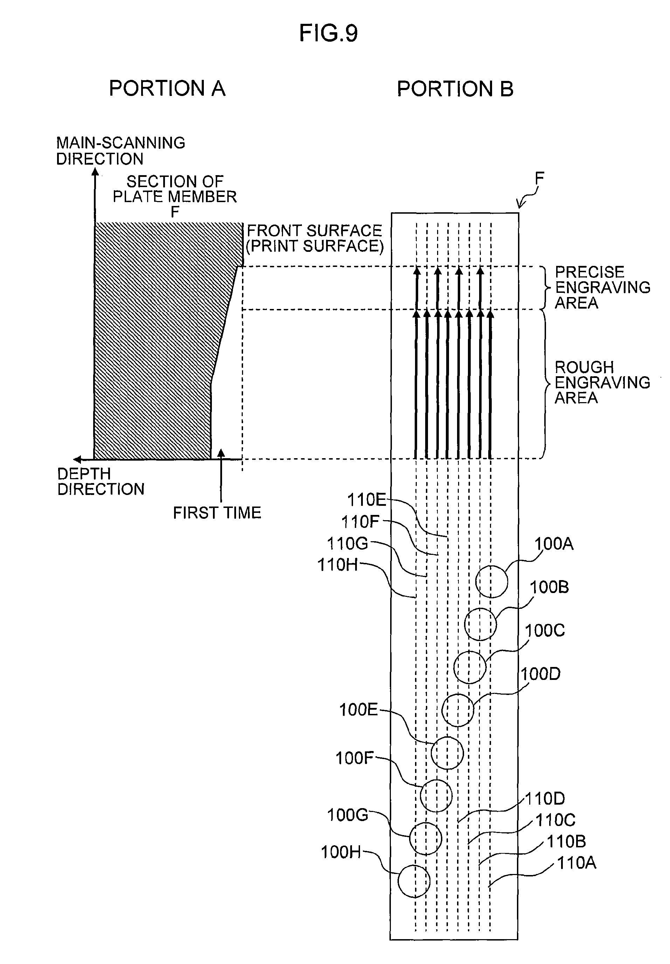

Fig. 9 to Fig. 12 are diagrams illustrating first to fourth exposure scanning at the same sub-scanning position. Portion A in each of Fig. 9 to Fig. 12 illustrates a section of the plate member F after engraving. Also, Portion B in each of Fig. 9 to Fig. 12 illustrates exposure control of laser beams 100A to 100H emitted from optical fiber ends 71A to 71H to scanning lines 110A to 110H, respectively. Here, for the purpose of description, the number of laser beams is decreased in the drawings, and an example is illustrated in which the plate member F is subjected to a main scan with the laser beams 100A to 100H relatively in an upper direction in each drawing.

Also, strictly speaking, the section of the plate member F illustrated in Portion A of each of Fig. 9 to Fig. 12 has a different degree of engraving depth depending on which scanning line among the laser beams 100A to 100D the section is on. Here, however, an average engraving dept of the section on each scanning line is illustrated.

First, in a first main scan at a relevant sub-scanning position, as illustrated in Portion B of Fig. 9, non-interlaced exposure is performed on the rough engraving area by using all of the laser beams 100A to 100H to engrave each of the scanning lines 110A to 110H. When exposure is performed with a plurality of beams arranged in a diagonal direction, with heat of the beam at the previous scanning, the depth ratio of engraving with the beam for the next scanning is increased. Therefore, by performing engraving in this manner, an inflow of heat of adjacent beams is promoted, thereby improving engraving efficiency.

Also, in the rough engraving area, control is performed so that outputs of the laser beams 100A to 100H are linearly decreased as coming closer to the precise engraving area, thereby preventing unwanted engraving due to an inflow of heat into the precise engraving area.

Furthermore, in the precise engraving area, interlaced exposure is performed by using a beam group with an interval between adjacent beams twice as large as the interval between the scanning lines, thereby engraving a scanning line in every other line. Here, as illustrated in Portion B of Fig. 9, among the laser beams 100A to 100H emitted from the optical fiber ends 71 A to 71 H, 100B, 100D, 100F, and 100H (a first beam group) are used for exposure scanning, thereby engraving the scanning lines 110B, 110D, 110F, and 110H.

With this control, the influence of heat occurring due to previously-passing adjacent beams can be mitigated. Therefore, in the precise engraving area, only the scanning lines 110B, 110D, 110F, and 110H can be precisely engraved with the laser beams 100B, 100D, 100F, and 100H.

Outputs of the laser beams 100B, 100D, 100F, and 100H emitted to the precise engraving area are preferably higher than those emitted to the rough engraving area. That is, when exposure is simultaneously performed with only a plurality of beams arranged in the sub-scanning direction, by increasing laser beam power by an amount of engraving efficiency improved by simultaneously performing exposure with a plurality of beams arranged in a diagonal direction, the engraving depth and engraving width for one main scan can be both made similar, and therefore continuity between the precise engraving area and the rough engraving area can be kept.

Also in the precise engraving area, outputs of the laser beams 100B, 100D, 100F, and 100H are controlled to be linearly decreased as coming closer to the print surface. With this control, the influence of heat occurring due to the previously-passing adjacent beams can be mitigated, and therefore unwanted engraving due to an inflow of heat into the print surface can be prevented.

As a result, as illustrated in Portion A of Fig. 9, engraving is performed on the surface of the plate member F. That is, in the rough engraving area, the engraving depth is shallower as coming closer to the precise engraving area. In the precise engraving area, only the scanning lines 110B, 110D, 110F, and 110H are engraved.

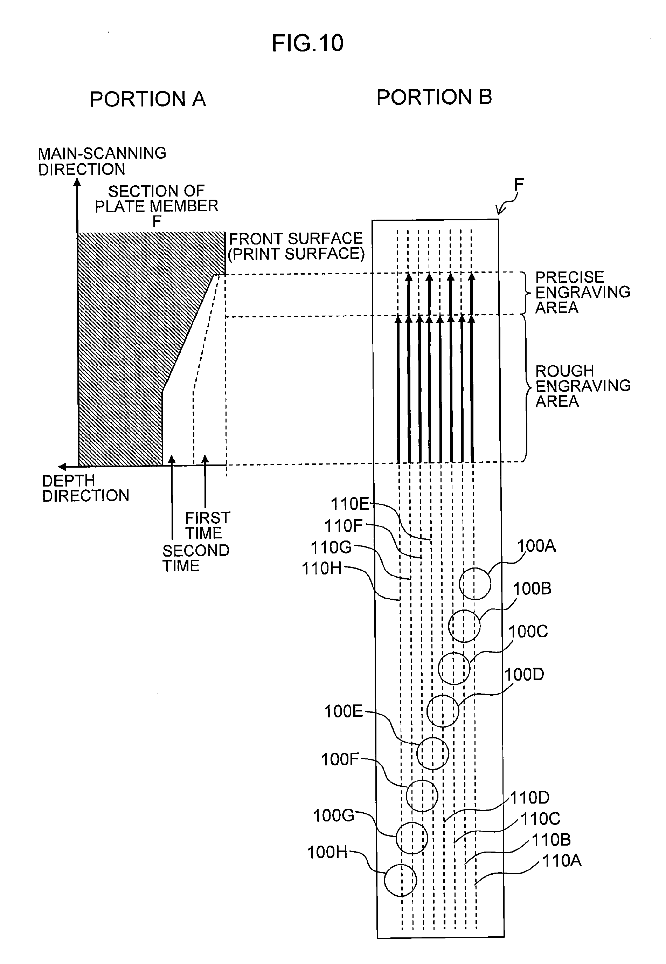

In a second main scan, as illustrated in Portion B of Fig. 10, in the rough engraving area, non-interlaced exposure is performed by using all of the laser beams 100A to 100H to promote an inflow of heat of the adjacent beams to improve engraving efficiency, thereby engraving the scanning lines 110A to 110H. Also, as with the first main scan, control is performed so that outputs of the laser beams 100A to 100H are linearly decreased as coming closer to the precise engraving area.

Furthermore, in the precise engraving area, interlaced exposure is performed by using a beam group with an interval between adjacent beams twice as large as the interval between the scanning lines and not used at the first time, thereby engraving scanning lines not engraved at the first time. That is, as illustrated in Portion B of Fig. 10, among the laser beams 100A to 100H emitted from the optical fiber ends 71A to 71H, the laser beams 100A, 100C, 100E, and 100G (a second beam group) are used for exposure scanning, thereby engraving the scanning lines 110A, 110C, 110E, and 110G. With this control, the influence of heat occurring due to the previously-passing adjacent beams can be mitigated, and therefore only the scanning lines 110A, 110C, 110E, and 110G exposed with the laser beams 100A, 100C, 100E, and 100G can be precisely engraved in the precise engraving area.

As with the first main scan, outputs of the laser beams 100A, 100C, 100E, and 100G emitted to the precise engraving area are preferably higher than outputs emitted to the rough engraving area. With this, the engraving depth and engraving width for one main scan can be both made similar, and therefore continuity between the precise engraving area and the rough engraving area can be kept.

Also in the precise engraving area, an output of the laser beam 100D is controlled to be linearly decreased as coming closer to the print surface. With this control, unwanted engraving due to an inflow of heat into the print surface can be prevented.

As a result, the surface of the plate member F is subjected to engraving as illustrated in Portion A of Fig. 10. That is, the rough engraving area is subjected to engraving deeper than the section at the first time, with the engraving depth becoming shallower as coming closer to the precise engraving area. Also, the scanning lines 110B, 110D, 110F, and 110H engraved at the first time and the scanning lines 110A, 110C, 110E, and 110G engraved at the second time are present in the precise engraving area. That is, with these two exposures, all of the scanning lines are uniformly engraved at the sub-scanning positions. Also, as with the rough engraving area, the engraving depth becomes shallower as coming closer to the print surface.

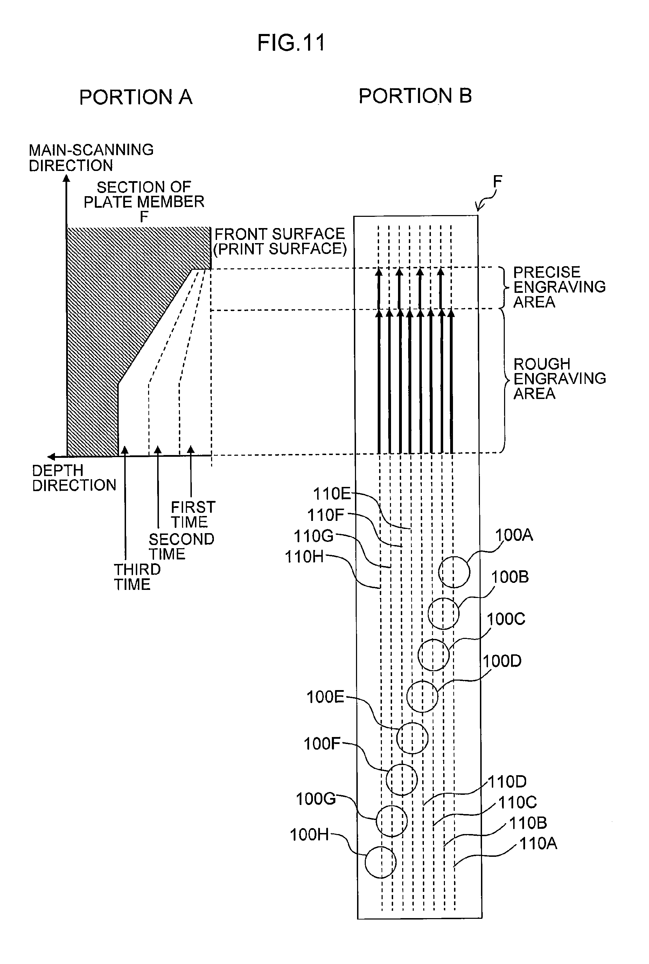

In a third main scan, as illustrated in Portion B of Fig. 11, in the rough engraving area, as with the first and second main scan, non-interlaced exposure is performed by using the laser beams 100A to 100H, thereby engraving the scanning lines 110A to 110H. Also, in the precise engraving area, interlaced exposure (superposed exposure) is performed by using a beam group with an interval between adjacent beams twice as large as the interval between the scanning lines, thereby engraving a scanning line in every other line. Here, as illustrated in Portion B of Fig. 11, exposure scanning is performed by using the same first beam group as used in the first exposure scanning, thereby engraving the scanning lines 110B, 110D, 110F, and 110H.

As a result, the surface of the plate member F is subjected to engraving as illustrated in Portion A of Fig. 11. That is, the rough engraving area is subjected to engraving further deeper than the section at the second time, and the scanning lines 110B, 110D, 110F, and 110H obtained by scanning with the first beam group are deeply engraved in the precise engraving area.

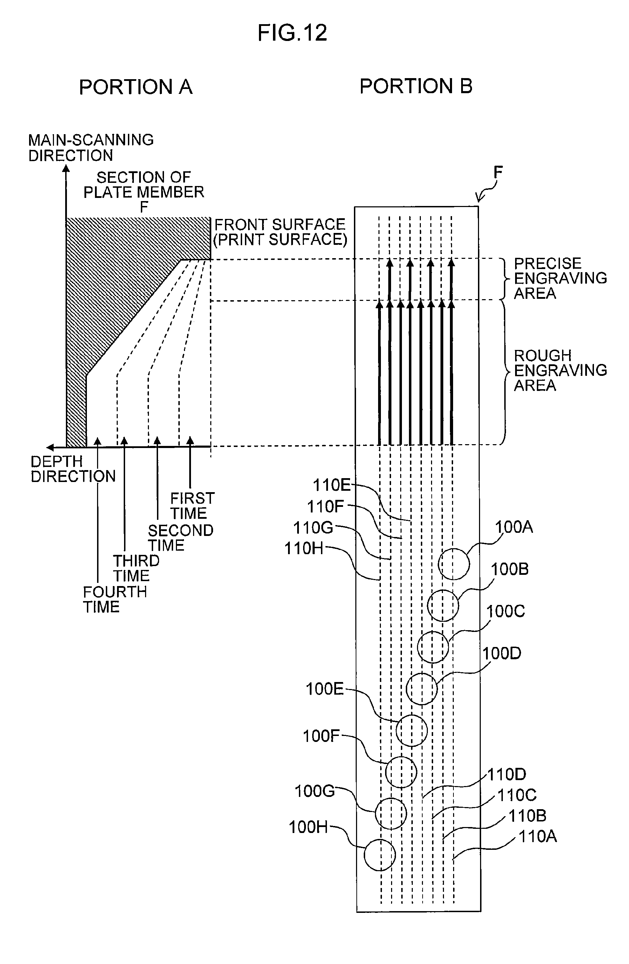

Similarly, in a fourth main scan, as illustrated in Portion B of Fig. 12, in the rough engraving area, non-interlaced exposure for a fourth time is performed with the laser beams 100A to 100H, thereby engraving the scanning lines 110A to 110H. Also, in the precise engraving area, interlaced exposure (superposed exposure) is performed by using a beam group with an interval between adjacent beams twice as large as the interval between the scanning lines and not used at the third time, thereby engraving scanning lines not engraved at the third time. Here, as illustrated in Portion B of Fig. 12, by using only the same second beam group as used in the second main scan, thereby engraving the scanning lines 110A, 110C, 110E, and 110G.

As a result, the surface of the plate member F is subjected to engraving as illustrated in Portion A of Fig. 12. That is, the rough engraving area is subjected to engraving further deeper than the section at the third time, with the engraving depth becoming shallower as coming closer to the precise engraving area. Also, in the precise engraving area, all of the scanning lines at the sub-scanning positions are uniformly engraved with the third and fourth main scans. Furthermore, in the precise engraving area, engraving is performed so that an steep edge portion with respect to the print surface is eventually formed.

After engraving for one swath is complete with four rotations of the drum 50 in the manner described above, when the chuck member 55 in the non-recording area intermittently feeds the exposure head 30 in the sub-scanning direction (in a right direction in Fig. 6) when going across the front of the exposure head 30 to move the exposure head 30 to a position for engraving for the next adjacent one swath. Then, at this position, exposure scanning as illustrated in Fig. 9 to Fig. 12 is similarly performed at that position. Thereafter, the processes described above are repeated to expose the entire surface of the plate member F.

As described above, the beam group with an interval between adjacent beams twice as large as the interval between the scanning lines is used in the peripheral part (the precise engraving area) of the surface shape to be eventually left as a projected flat part. With scanning lines to be exposed with a plurality of times of scanning being varied, unexposed scanning lines between exposed scanning lines are sequentially exposed.

By repeating this interlaced exposure four times for repetitive superposed exposure, it is possible to reduce the influence of heat of adjacent beams occurring before superposed exposure, vibrations in the main-scanning direction and the sub-scanning direction at the time of rotation of the drum, positional statically determinate accuracy of the exposure head and feed accuracy in sub-scanning, periodic unevenness due to, for example, an error associated with an error in pitch space in the sub-scanning direction of the array, and vibration unevenness. With this, the target flat shape and the shape of its surrounding tilted part can be appropriately engraved.

Furthermore, in its peripheral part (the rough engraving area), beams are simultaneously emitted from the emission port line at all stages to promote an inflow of heat of the adjacent beams. With this, engraving efficiency can be improved.

Here, while interlaced exposure is repeatedly preformed on the precise engraving area four times by using a beam group with an interval between adjacent beams twice as large as the interval between the scanning lines to expose each scanning line twice and non-interlaced exposure is performed on the rough engraving area four times by using a beam group with an interval between adjacent beams equal to the interval between the scanning lines, these values can be appropriately determined. That is, it can be configured interlaced exposure using a beam group with an interval between adjacent beams N times (N is an integer equal to 2 or more) larger than the interval between the scanning lines is repeatedly performed Nxm times (m is an integer equal to 2 or more) on the precise engraving area to expose each scanning line m times and non-interlaced exposure using a beam group with an interval between adjacent beams equal to the interval between the scanning lines is performed Nxm times on the rough engraving area. For these N and m, any desired numbers can be combined as appropriate as long as they are each equal to 2 or more.

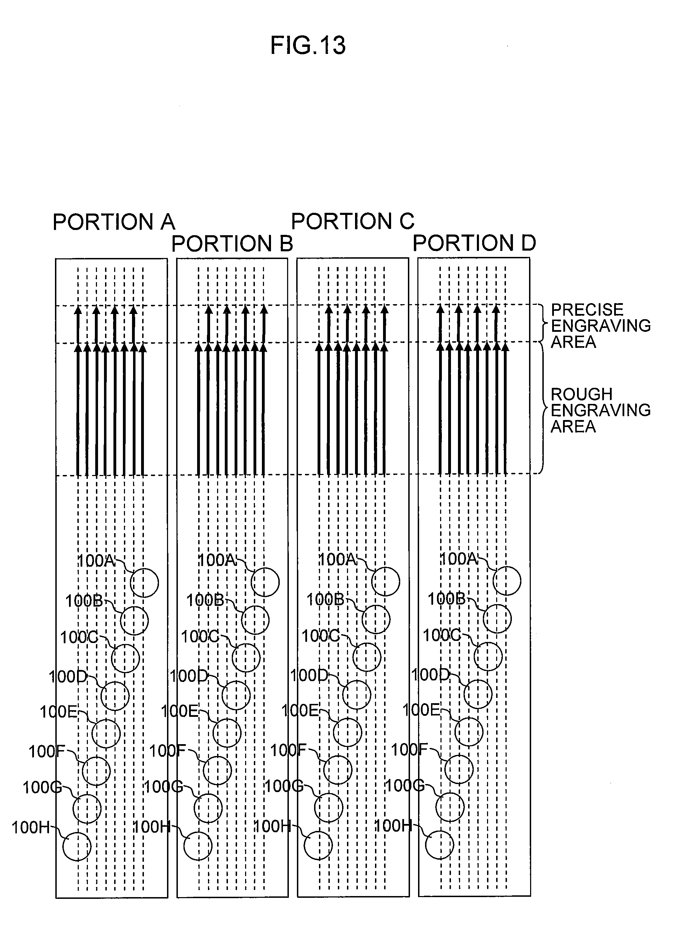

Also, the sequence of interlaced exposure may not be the same as the sequence of exposure scanning illustrated in Fig. 9 to Fig. 12. For example, as illustrated in Fig. 13, exposure in the first main scan may be performed by the first beam group (Portion A of Fig. 13), exposure in the second main scan may be next performed by the second beam group (Portion B of Fig. 13), exposure in the third main scan may be then performed again by the second beam group (Portion C of Fig. 13), and exposure in the fourth main scan may be performed by the first beam group (Portion D of Fig. 13). As such, interlaced exposure is not necessarily restricted to alternate exposure. Also, it goes without saying that the sequence may be such that the first beam group and the second beam group are exchanged with each other.

### <Sub-scanning feed of the exposure head>

### [Movement by 32 ch for every four main scans]

In the exposure scanning described by using Fig. 9 to Fig. 12, after engraving for one swath is complete with four rotations of the drum 50, the exposure head 30 is moved in the sub-scanning direction by one swath (by 32 ch=(interval between the scanning lines)×32).

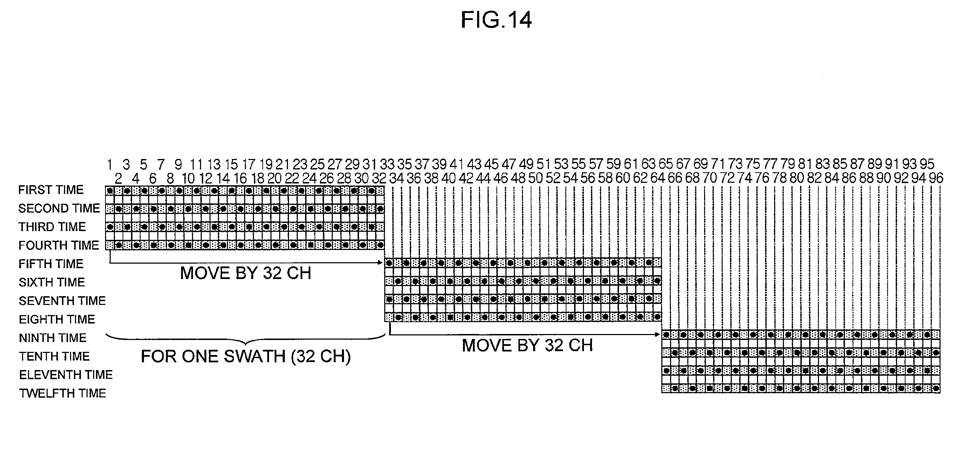

Fig. 14 is a diagram schematically illustrating this state. In Fig. 14, each square represents each of the optical fiber ends 71 of the exposure head 30. Also, among the optical fiber ends 71, hatched portions each represent that a laser beam output is performed in the rough engraving area. Black circle portions each represent that a laser beam output is performed in the precise engraving area.

As illustrated in Fig. 14, in a first exposure, all beam groups are used for exposure in the rough engraving area, and a beam group with an interval between adjacent beams twice as large as the interval between the scanning lines is used for exposure in the precise engraving area.

In a second exposure, all beam groups are used for exposure in the rough engraving area, and a beam group with an interval between adjacent beams twice as large as the interval between the scanning lines and not used at the first time is used for exposure in the precise engraving area.

In a third exposure, all beam groups are used for exposure in the rough engraving area, and the same beam group with the interval between adjacent beams twice as large as the interval between the scanning lines and used at the first time is used for exposure in the precise engraving area.

In a fourth exposure, all beam groups are used for exposure in the rough engraving area, and the same beam group with the interval between adjacent beams twice as large as the interval between the scanning lines and used at the second time is used for exposure in the precise engraving area.

With these four main scans, exposure for one swath (32 ch) completely ends. Next, the exposure head 30 is moved by 32 ch in the sub-scanning direction (in a right direction in Fig. 14). Then, at this position, four exposures are performed for exposure for 32 ch.

As such, in the example described with reference to Fig. 9 to Fig. 12, each scanning line is exposed with the same beam. Also here, a sub-scanning feed by 32 ch corresponding to a total number beams of the exposure head 30 is performed. That is, a sub-scanning feed is performed by an amount equal to the product of the total number of beams and the scanning line width.

### [Movement by 29 ch for every four main scans]

The sub-scanning feed is not meant to be restricted to the example illustrated in Fig. 14. In the sub-scanning feed corresponding to the total number of beams of the head 30, a residual unengraved portion between swathes may occur. To prevent this, an area with redundant beam groups may be provided for a sub-scanning feed.

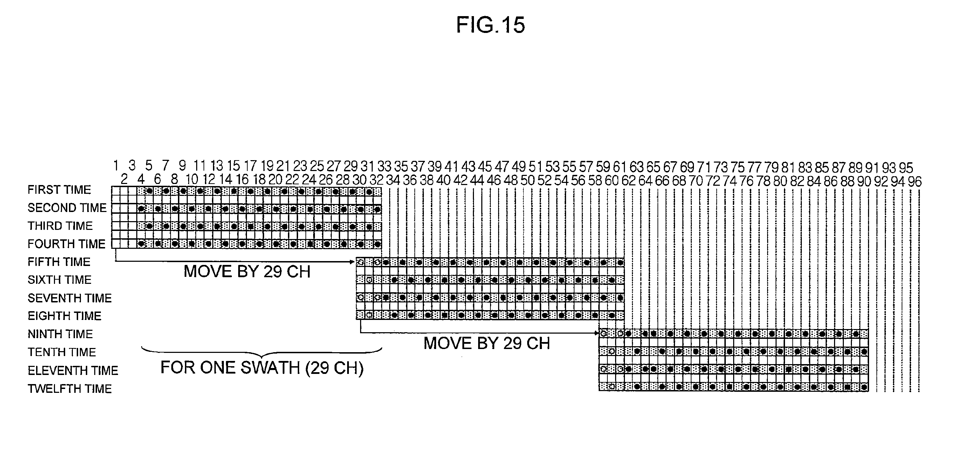

Fig. 15 is a diagram illustrating the case of a sub-scanning feed by 29 ch after four scans. As illustrated in the drawing, a beam group for 3 ch from left is not used in first to fourth exposures. Other than that, the control is similar to that in exposure illustrated in Fig. 14.

Therefore, with four main scans, exposure for one swath (29 ch) completely ends. Next, the exposure head 30 is moved by 29 ch in the sub-scanning direction (in a right direction in Fig. 15).

In the next four main scans, all beam groups are used in the rough engraving area. That is, 30th, 31st, and 32nd lines from left of the plate member F are exposed with beams for 3 ch from right of the head 30 in the first to fourth main scans, and are further exposed with beams for 3 ch from left of the head 30 in fifth to eighth main scans. With this exposure, a residual unengraved portion between swathes can be suppressed.

Also, while the beam group with an interval between adjacent beams twice as large as the interval between the scanning lines is used for exposure in the precise engraving area, the beam group for 3 ch from left may be exposed as required at the time of the fifth to eighth main scans.

As such, each scanning line can be exposed with the same beam, and an area with redundant beam groups can also be provided for a sub-scanning feed. That is; a sub-scanning feed may be performed for an amount smaller than the product of the total number of beams and the scanning line width by a predetermined amount.

### [Movement by 8 ch for every main scan]

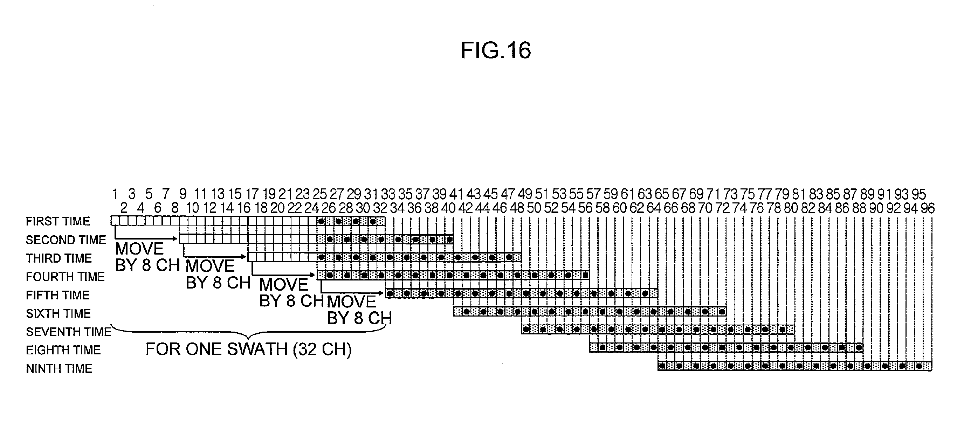

While the main scan is performed four times at each sub-scanning position in the examples illustrated in Fig. 14 and Fig. 15, the main scan can be performed once at each sub-scanning position. Fig. 16 is a diagram schematically illustrating a sub-scanning feed by 8 ch for every main scan.

As illustrated in Figs. 14-16, a start line of an image to be exposed is set at a 25th line. In a first exposure, a beam groups for 24 ch from left is not used. The all remaining beam groups are used for exposure in the rough engraving area, and a beam group with an interval between adjacent beams twice as large as the interval between the scanning lines is used for exposure in the precise engraving area.

Next, a sub-scanning feed for 8 ch (the interval between the scanning lines×8) is performed for a second exposure. In the second exposure, a beam group for 16 ch from left is not used. Then, the all remaining beam groups are used for exposure in the rough engraving area, and a beam group with an interval between adjacent beams twice as large as the interval between the scanning lines and different from that for the first time is used for exposure in the precise engraving area.

Next, a sub-scanning feed for 8 ch is performed for a third exposure. In the third exposure, a beam group for 8 ch from left is not used. Then, the all remaining beam groups are used for exposure in the rough engraving area, and a beam group with an interval between adjacent beams twice as large as the interval between the scanning lines and the same as that for the first time is used for exposure in the precise engraving area.

Furthermore, a sub-scanning feed for 8 ch is performed for a fourth exposure. In the fourth exposure, all beam groups are used for exposure in the rough engraving area, and a beam group with an interval between adjacent beams twice as large as the interval between the scanning lines and the same as that for the second time is used for exposure in the precise engraving area.

With these four main scans, exposure of 25th to 32nd lines from left of the plate member F completely ends.

Next, a sub-scanning feed for 8 ch is performed for a fifth exposure. In the fifth exposure, all beam groups are used for exposure in the rough engraving area, and a beam group with an interval between adjacent beams twice as large as the interval between the scanning lines and the same as that for the first time is used for exposure in the precise engraving area.

With four main scans at second to fifth times, exposure of 33rd to 40th lines from left of the plate member F completely ends. Then, similarly, one main scan and a sub-scan for 8 ch are repeatedly performed.

As such, sub-scanning may be equidistantly performed for every main scan. While a sub-scanning feed is performed for 8 ch is performed herein, the number of sub-scanning feed is any as long as it is a submultiple of the number of beams (32 ch). That is, a sub-scanning can be performed for an amount equal to a submultiple of the number of beams and the scanning line width.

Also, in place of intermittent feeds, a spiral exposure scheme may be adopted in which the exposure head 30 is moved at a predetermined speed in the sub-scanning direction during the rotation of the drum 50 for scanning the surface of the plate member F in a spiral shape.

The intermittent feed scheme is effective when the rotation speed of the drum is relatively slow. On the other hand, the spiral exposure scheme is effective when the rotation speed of the drum is relatively quick.

### [Movement by 7 ch or 9 ch for every main scan]

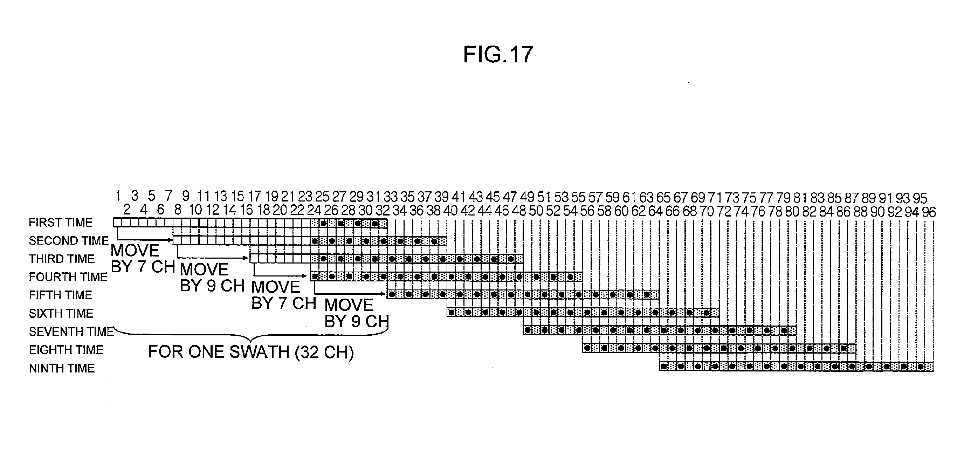

While a sub-scanning feed is equidistantly performed for every main scan in the example illustrated in Fig. 16, a sub-scanning feed may be non-equidistantly performed for every main scan. Fig. 17 is a diagram schematically illustrating a sub-scanning feed for 7 ch or 9 ch for every scan.

As illustrated in Figs. 16-17, in a first exposure, a beam group for 23 ch from left is not used. Then, the all remaining beam groups are used for exposure in the rough engraving area, and a beam group with an interval between adjacent beams twice as large as the interval between the scanning lines is used for exposure in the precise engraving area.

Next, a sub-scanning feed for 7 ch is performed in a second exposure. In the second exposure, a beam group for 16 ch from left is not used. Then, the all remaining beam groups are used for exposure in the rough engraving area.

In the precise engraving area, since 25th, 27th, 29th and 31st lines from left of the plate member F have been exposed in the first exposure, 24th, 26th, 28th, 30th, 32nd, 34th, 36th, and 38th lines from left of the plate member F are exposed in this exposure. Here, since the sub-scanning feed is for odd-number ch, a beam group with an interval between adjacent beams twice as large as the interval between the scanning lines and the same as that at the first time is used for exposure in the precise engraving area.

Next, a sub-scanning feed for 9 ch is performed in a third exposure. In the third exposure, a beam group for 7 ch from left is not used. Then, the all remaining beam groups are used for exposure in the rough engraving area.

In the precise engraving area, since the 24th, 26th, 28th, 30th, 32nd, 34th, 36th, and 38th lines from left of the plate member F have been exposed in the second exposure, 25th, 27th, 29th, 31st, 33rd, 35th, 37th, 39th, 41st, 43rd 45th, and 47th lines from left of the plate member F are exposed in this exposure. Here, since the sub-scanning feed is for odd-number ch, a beam group with an interval between adjacent beams twice as large as the interval between the scanning lines and the same as that at the second time is used for exposure in the precise engraving area.

Next, a sub-scanning feed for 7 ch is performed in a fourth exposure. In the fourth exposure, all beam groups are used for exposure in the rough engraving area. In the precise engraving area, similarly to the above, a beam group with an interval between adjacent beams twice as large as the interval between the scanning lines and the same as that at the third time is used for exposure.

With these four scans, exposure of nine lines from the 24th to 32nd lines from left of the plate member F completely ends.

Furthermore, a sub-scanning feed for 9 ch is performed in a fifth exposure. Also in the fifth exposure, all beam groups are used for exposure in the rough engraving area, and a beam group with an interval between adjacent beams twice as large as the interval between the scanning lines and the same as ever is used for exposure in the precise engraving area.

With four main scans at the second to fifth times, exposure of seven lines from the 33rd to 39th lines from left of the plate member F completely ends.

Thereafter, similarly, one main scan and sub-scans for 7 ch or 9 ch are repeated. As such, by sequentially performing sub-scanning feed non-equidistantly, that is, with a plurality of feed amounts, a residual unengraved portion between swathes can be reduced. Note that while the head from which 32 laser beams are simultaneously emitted has been described herein as an example, the number of beams and the amount of sub-scanning feed can be determined as appropriate.

### <Regarding the flexographic plate manufacturing process>

Next, an exposure scanning process when a printing plate is manufactured by a multi-beam exposure system is described.

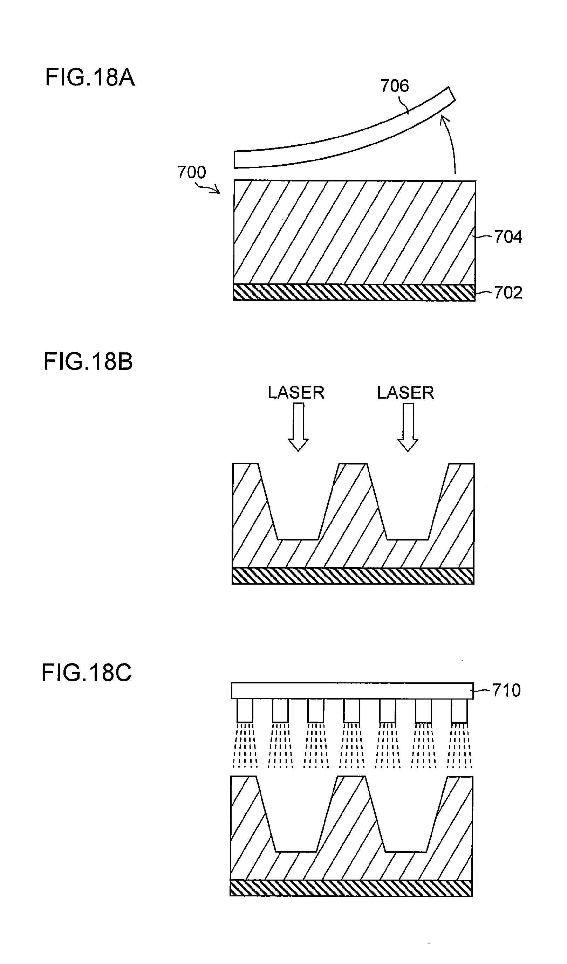

Figs. 18A, 18B, and 18C illustrate an overview of a plate making method. A raw plate 700 for use in plate making by laser engraving has an engraving layer 704 (a rubber layer or a resin layer) on a substrate 702, and a protective cover film 706 is affixed onto the engraving layer 704. At the time of a plate making process, as illustrated in Fig. 18A, the engraving layer 704 is exposed to the outside by peeling off the cover film 706, and the engraving layer 704 is irradiated with laser light, thereby removing unit of the engraving layer 704 and forming a desired three-dimensional shape (refer to Fig. 18B). A specific laser engraving method is as described with reference to Fig. 1 to Fig. 17. Note that dust occurring during laser engraving is suctioned by a suctioning apparatus not illustrated for collection.

After the engraving process ends, as illustrated in Fig. 18C, water cleaning by a cleaning apparatus 710 is performed (a cleaning process). Then, after a drying process (not illustrated), a flexographic plate is complete.

As such, a plate making scheme of direct laser engraving on the plate itself is called a direct engraving scheme. The plate making apparatus to which the multi-beam exposure scanning apparatus according to the present embodiment is applied can be achieved at lower cost, compared with a laser engraving machine using CO₂ laser. Also, by making beams into multi-beam, an improvement in processing speed can be achieved, thereby improving productivity of printing plates.

### <Other examples of application>

The presently disclosed subject matter can be applied not only to manufacture of a flexographic plate but also to manufacture of another relief printing plate or an intaglio printing plate. Furthermore, the presently disclosed subject matter can be applied not only to manufacture of a printing plate but also to a rendering recording apparatus and engraving apparatus for other various purposes.

### <Note>

As can be understood from the detailed description of the embodiment above, the specification includes disclosure of various technical ideas including the following aspects of the presently disclosed subject matter.

### (First Aspect)

A multi-beam exposure scanning method in which a plurality of beams are simultaneously emitted with a predetermined interval between scanning lines toward a recording medium for exposure scanning a plurality of times with a same scanning line, thereby performing engraving on a surface of the recording medium, wherein interlaced exposure using a beam group with an interval between adjacent beams N times (N is an integer equal to 2 or more) larger than the interval between the scanning lines is repeatedly performed Nxm times (m is an integer equal to 2 or more) on a first area, which is an area surrounding a flat-shaped target area to be left on the surface of the recording medium to be exposed, to expose each of the scanning lines m times, and non-interlaced exposure using a beam group with an interval between adjacent beams equal to the interval between the scanning lines is performed on a second area, which is outside the first area.

With this, periodic uneven streaks can be reduced.

### (Second Aspect)

In the multi-beam exposure scanning method according to the first aspect of the presently disclosed subject matter, the non-interlaced exposure is repeatedly performed Nxm times on the second area.

With this, deep engraving can be performed on the second area.

### (Third Aspect)

In the multi-beam exposure scanning method according to the first aspect of the presently disclosed subject matter, a shape of a tilted part surrounding the flat-shaped target area is engraved by decreasing outputs of beams as coming closer to the flat-shaped target area to be left on the surface of the recording medium to be exposed.

With this, the shape of the tilted part around the target flat shape can be engraved.

### (Fourth Aspect)

A multi-beam exposure scanning apparatus including an exposure head simultaneously emitting a plurality of beams toward a recording medium to perform engraving on a surface of the recording medium, main-scanning means relatively moving the recording medium and the exposure head in a main-scanning direction for exposure scanning a plurality of times with a same scanning line, and exposure scanning control means controlling the exposure head and the main-scanning means so that interlaced exposure using a beam group with an interval between adjacent beams N times (N is an integer equal to 2 or more) larger than the interval between the scanning lines is repeatedly performed Nxm times (m is an integer equal to 2 or more) on a first area, which is an area surrounding a flat-shaped target area to be left on the surface of the recording medium to be exposed, to expose each of the scanning lines m times, and non-interlaced exposure using a beam group with an interval between adjacent beams equal to the interval between the scanning lines is performed on a second area, which is outside the first area.

With this, periodic uneven streaks can be reduced.

### (Fifth Aspect)

In the multi-beam exposure scanning apparatus according to the fourth aspect of the presently disclosed subject matter, the non-interlaced exposure is repeatedly performed Nxm times on the second area.

With this, deep engraving can be performed on the second area.

### (Sixth Aspect)

The multi-beam exposure scanning apparatus according to the fourth or fifth aspect of the presently disclosed subject matter further includes sub-scanning means causing the exposure head to perform sub-scanning the recording medium relatively in a sub-scanning direction orthogonal to the main-scanning direction, wherein the sub-scanning means causes the sub-scanning intermittently by a predetermined amount with respect to main-scanning by the main-scanning means.

With this, engraving can be performed on the entire recording medium.

### (Seventh Aspect)

In the multi-beam exposure scanning apparatus according to the sixth aspect of the presently disclosed subject matter, the sub-scanning means causes the sub-scanning by a predetermined amount for every Nxm main scans by the main-scanning means.

With this, sub-scanning can be appropriately performed.

### (Eighth Aspect)

In the multi-beam exposure scanning apparatus according to the seventh aspect of the presently disclosed subject matter, the predetermined mount is equal to a product of a number of beams that can be emitted from the exposure head and the interval between the scanning lines.

With this, sub-scanning can be appropriately performed.

### (Ninth Aspect)

In the multi-beam exposure scanning apparatus according to the seventh aspect of the presently disclosed subject matter, the predetermined amount is smaller than a product of a number of beams that can be emitted from the exposure head and the interval between the scanning lines.

With this, sub-scanning can be appropriately performed.

### (Tenth Aspect)

In the multi-beam exposure scanning apparatus according to the sixth aspect of the presently disclosed subject matter, the sub-scanning means causes the sub-scanning by a predetermined amount for every main scan by the main-scanning means.

With this, sub-scanning can be appropriately performed.

### (Eleventh Aspect)

In the multi-beam exposure scanning apparatus according to the tenth aspect of the presently disclosed subject matter, the predetermined amount is equal to a submultiple of a product of a number of beams that can be emitted from the exposure head and the interval between the scanning lines.

With this, sub-scanning can be appropriately performed.

### (Twelfth Aspect)

In the multi-beam exposure scanning apparatus according to the tenth aspect of the presently disclosed subject matter, the predetermined amount has a plurality of values.

With this, sub-scanning can be appropriately performed.

### (Thirteenth Aspect)

In the multi-beam exposure scanning apparatus according to the fourth aspect of the presently disclosed subject matter, the main-scanning means has a drum rotating as holding the recording medium by an outer circumferential surface, the apparatus further includes sub-scanning means moving the exposure head along an axial direction of the drum, wherein spiral exposure scanning is performed with a sub-scanning feed parallel to an axial direction of the drum being taken as a continuous feed.

With this, sub-scanning can be appropriately performed.

### (Fourteenth Aspect)

A printing plate manufacturing method wherein, with the multi-beam exposure scanning method according to any one of the first to third aspects of the presently disclosed subject matter, a printing plate is obtained by performing engraving on a surface of a plate member corresponding to the recording medium.

With this, a printing plate with reduced periodic uneven streaks can be obtained.

## Claims

1. A multi-beam exposure scanning method comprising: simultaneously emitting a plurality of beams with a predetermined interval between scanning lines toward a recording medium (F); and performing engraving on a surface of the recording medium by performing exposure scanning a plurality of times with a same scanning line, the method further comprising:
repeatedly performing interlaced exposure using a beam group with an interval between adjacent beams N times (N is an integer equal to 2 or more) larger than the interval between the scanning lines Nxm times (m is an integer equal to 2 or more) on a first area, which is an area surrounding a flat-shaped target area to be left on the surface of the recording medium to be exposed, to expose each of the scanning lines m times; and
performing non-interlaced exposure using a beam group with an interval between adjacent beams equal to the interval between the scanning lines on a second area, which is outside the first area.

2. The multi-beam exposure scanning method according to claim 1, wherein
the non-interlaced exposure is repeatedly performed Nxm times on the second area.

3. The multi-beam exposure scanning method according to claim 1 or 2, wherein
a shape of a tilted part surrounding the flat-shaped target area is engraved by decreasing outputs of beams as coming closer to the flat-shaped target area to be left on the surface of the recording medium to be exposed.

4. A multi-beam exposure scanning apparatus (10) comprising:
an exposure head (30) configured to simultaneously emit a plurality of beams toward a recording medium (F) to perform engraving on a surface of the recording medium;
main-scanning means (51, 80, 81) configured to relatively move the recording medium and the exposure head in a main-scanning direction for exposure scanning a plurality of times with a same scanning line; and
exposure scanning control means (21, 26, 80) configured to control the exposure head and the main-scanning means so that interlaced exposure using a beam group with an interval between adjacent beams N times (N is an integer equal to 2 or more) larger than the interval between the scanning lines is repeatedly performed Nxm times (m is an integer equal to 2 or more) on a first area, which is an area surrounding a flat-shaped target area to be left on the surface of the recording medium to be exposed, to expose each of the scanning lines m times, and non-interlaced exposure using a beam group with an interval between adjacent beams equal to the interval between the scanning lines is performed on a second area, which is outside the first area.

5. The multi-beam exposure scanning apparatus according to claim 4, wherein
the non-interlaced exposure is repeatedly performed Nxm times on the second area.

6. The multi-beam exposure scanning apparatus according to claim 4 or 5, further comprising
sub-scanning means (43, 80, 82) configured to relatively move the exposure head to perform sub-scanning the recording medium in a sub-scanning direction orthogonal to the main-scanning direction, wherein
the sub-scanning means performs the sub-scanning intermittently by a predetermined amount with respect to main-scanning by the main-scanning means.

7. The multi-beam exposure scanning apparatus according to claim 6, wherein
the sub-scanning means performs the sub-scanning by a predetermined amount for every Nxm main scans by the main-scanning means.

8. The multi-beam exposure scanning apparatus according to claim 7, wherein
the predetermined mount is equal to a product of a number of beams that can be emitted from the exposure head and the interval between the scanning lines.

9. The multi-beam exposure scanning apparatus according to claim 7, wherein
the predetermined amount is smaller than a product of a number of beams that can be emitted from the exposure head and the interval between the scanning lines.

10. The multi-beam exposure scanning apparatus according to claim 6, wherein
the sub-scanning means causes the sub-scanning by a predetermined amount for every main scan by the main-scanning means.

11. The multi-beam exposure scanning apparatus according to claim 10, wherein
the predetermined amount is equal to a submultiple of a product of a number of beams that can be emitted from the exposure head and the interval between the scanning lines.

12. The multi-beam exposure scanning apparatus according to claim 10, wherein the predetermined amount has a plurality of values.

13. The multi-beam exposure scanning apparatus according to claim 4, wherein
the main-scanning means includes a drum configured to rotate as holding the recording medium by an outer circumferential surface of the drum,
the apparatus further includes a sub-scanning means configured to move the exposure head along an axial direction of the drum, wherein
spiral exposure scanning is performed with a sub-scanning feed parallel to an axial direction of the drum being taken as a continuous feed.

14. A printing plate manufacturing method wherein,
with the multi-beam exposure scanning method according to any one of claims 1 to 3, a printing plate is obtained by performing engraving on a surface of a plate member corresponding to the recording medium.
